(19) Europäisches Patentamt
European Patent Office
Office européen des brevets

(11) **EP 4 679 644 A1**

(12) **EUROPEAN PATENT APPLICATION**
published in accordance with Art. 153(4) EPC

(43) Date of publication:
**14.01.2026 Bulletin 2026/03**

(21) Application number: **23926167.0**

(22) Date of filing: **03.03.2023**

(51) International Patent Classification (IPC):
**H01S 5/062** (2006.01)

(52) Cooperative Patent Classification (CPC):
**H01S 5/062**

(86) International application number:
**PCT/JP2023/008014**

(87) International publication number:
**WO 2024/184951 (12.09.2024 Gazette 2024/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nisshinbo Micro Devices Inc.
Tokyo 103-8456 (JP)**

(72) Inventors:
• **MATSUI, Makoto
  Tokyo 103-8456 (JP)**
• **SUMINO, Daijiroh
  Tokyo 103-8456 (JP)**

(74) Representative: **SSM Sandmair
Patentanwälte Rechtsanwalt
Partnerschaft mbB
Joseph-Wild-Straße 20
81829 München (DE)**

(54) **SEMICONDUCTOR LASER DRIVE DEVICE**

(57)    A driver circuit (11) is connected in series to a semiconductor laser element (2), the driver circuit having a first terminal (P1) to which a bias voltage (Vbias) is applied, the driver circuit limiting a current flowing through the semiconductor laser element (2) so as not to exceed an upper limit corresponding to a magnitude of the bias voltage (Vbias). A switching circuit (12) is connected in series to the semiconductor laser element (2) and the driver circuit (11), the switching circuit having a second terminal (P2) to which a first pulse signal (Vsw) is applied, the switching circuit being repeatedly turned on and off according to the first pulse signal (Vsw). A compensation circuit (13) compensates for variations in voltage potential at the first terminal (P1) based on the first pulse signal (Vsw), the variations occurring when the switching circuit (12) is turned on and off.

FIG. 1

EP 4 679 644 A1

# Description

TECHNICAL FIELD

The present disclosure relates to a semiconductor laser drive device and a distance measurement apparatus.

BACKGROUND ART

Various drive circuits are used to operate semiconductor laser elements, such as laser diodes, at desired optical output, drive speed, power consumption, and the like.

For example, Patent Document 1 discloses a semiconductor laser drive circuit that modulates laser light of a semiconductor laser by an external modulation input signal. The circuit of Patent Document 1 is provided with a differential pair circuit including a pair of transistors, and the semiconductor laser is connected to one of the transistors constituting the differential pair circuit.

CITATION LIST

PATENT DOCUMENTS

PATENT DOCUMENT 1: Japanese Patent No. JP 6922505 B2

SUMMARY OF INVENTION

TECHNICAL PROBLEM

When the semiconductor laser element is driven using the differential pair circuit, it is necessary to increase the current flowing through the differential pair circuit, in order to increase the optical output of the semiconductor laser element. In addition, in order to drive the semiconductor laser element at a high speed, even when no current is flowing through one of two paths of the differential pair circuit, the one path including the semiconductor laser element, that is, when the semiconductor laser element is turned off, it is necessary to keep the current flowing through the other path as much as the current flowing when the semiconductor laser element is turned on. For this reason, when the semiconductor laser element is driven at a high output power and a high speed, a large current flows constantly, thus increasing power consumption. On the other hand, when the semiconductor laser element is driven using the differential pair circuit, the optical output and/or the speed may decrease when trying to reduce the power consumption of the semiconductor laser element. Thus, it is required to drive the semiconductor laser element so as to achieve all of high output power, high-speed driving, and low power consumption.

An object of the present disclosure is to provide a semiconductor laser drive device capable of driving a semiconductor laser element so as to achieve all of high output power, high-speed driving, and low power consumption. A further object of the present disclosure is to provide a distance measurement apparatus provided with such a semiconductor laser drive device.

SOLUTION TO PROBLEM

According to one aspect of the present disclosure, a semiconductor laser drive device for driving a semiconductor laser element is provided with: a driver circuit, a switching circuit, and a compensation circuit. The driver circuit is connected in series to the semiconductor laser element, the driver circuit having a first terminal to which a bias voltage is applied, the driver circuit being configured to limit a current flowing through the semiconductor laser element so as not to exceed an upper limit corresponding to a magnitude of the bias voltage. The switching circuit is connected in series to the semiconductor laser element and the driver circuit, the switching circuit having a second terminal to which a first pulse signal is applied, the switching circuit being repeatedly turned on and off according to the first pulse signal. The compensation circuit is configured to compensate for variations in voltage potential at the first terminal based on the first pulse signal, the variations occurring when the switching circuit is turned on and off.

ADVANTAGEOUS EFFECTS OF INVENTION

The semiconductor laser drive device according to one aspect of the present disclosure can drive the semiconductor laser element so as to achieve all of high output power, high-speed driving, and low power consumption.

BRIEF DESCRIPTION OF DRAWINGS

Fig. 1 is a block diagram showing a basic configuration of a semiconductor laser drive device 1 according to a first embodiment.
Fig. 2 is a circuit diagram showing an implementation example of the semiconductor laser drive device 1 of Fig. 1.
Fig. 3 is a diagram showing currents flowing in the semiconductor laser drive device 1 of Fig. 2 when an NMOS transistor M2 is turned on.
Fig. 4 is a diagram showing currents flowing in the semiconductor laser drive device 1 of Fig. 2 when an NMOS transistor M2 is turned off.
Fig. 5 is a timing chart showing an operation of the semiconductor laser drive device 1 of Fig. 2.
Fig. 6 is a block diagram showing a basic configuration of a semiconductor laser drive device 1A according to a modified embodiment of the first embodiment.

Fig. 7 is a circuit diagram showing an implementation example of the semiconductor laser drive device 1A of Fig. 6.

Fig. 8 is a timing chart showing an operation of a pulse generator circuit 31 of Fig. 6.

Fig. 9 is a block diagram showing a basic configuration of a distance measurement apparatus 40 according to a second embodiment.

Fig. 10 is a schematic view for explaining distance measurement with the distance measurement apparatus 40 of Fig. 9.

## DESCRIPTION OF EMBODIMENTS

Hereinafter, embodiments of the present disclosure will be described with reference to the drawings. Similar components are denoted by the same reference signs throughout the drawings.

## [FIRST EMBODIMENT]

A semiconductor laser element may be applied to a distance measurement apparatus, such as a time of flight (ToF) sensor. The ToF sensor measures a distance from the ToF sensor to a target object based on a propagation time of light from emission of the light toward the target object, to return of the light reflected by the target object.

Among ToF sensors, an indirect time of flight (iToF) type sensor causes a semiconductor laser element to repeatedly emit light thousands of times to tens of thousands of times, receives reflected light from a target object during and after light emission, and calculates a distance based on a ratio between a quantity of received light Q1 during light emission, and a quantity of received light Q2 after light emission. The iToF method does not require a complicated circuit, and easily improves resolution, as compared with a direct time of flight (dToF) method for measuring a distance based on a propagation time of one pulse of laser light. Thus, the iToF method is often adopted for three-dimensional ToF sensors of short and middle distances.

The semiconductor laser element for the iToF method mainly requires three features of high output power, high-speed driving, and low power consumption. In consideration of influences, such as atmospheric attenuation on forward and return paths between the semiconductor laser element and the target object, and reflection attenuation of the target object, a high output power (that is, a large optical output) is required to extend the maximum measurable distance. In addition, when a pulsed drive current supplied to the semiconductor laser element has a long rise time and a long fall time, the ratio between the quantities of received light Q1 and Q2 may vary, or the pulse width may vary, even in the case of measuring the same distance, and as a result, the accuracy of measurement deteriorates. Thus, it is required to drive the semiconductor laser element at a high speed with a short rise time and a short fall time. The iToF type sensor requires a driving speed of, e.g., 250 MHz or more. In addition, it is also required to reduce power consumption of the entire system to extend the battery life.

Hereinafter, a semiconductor laser drive device according an embodiment will be described, which is capable of driving a semiconductor laser element so as to achieve all of high output power, high-speed driving, and low power consumption.

## [CONFIGURATION OF FIRST EMBODIMENT]

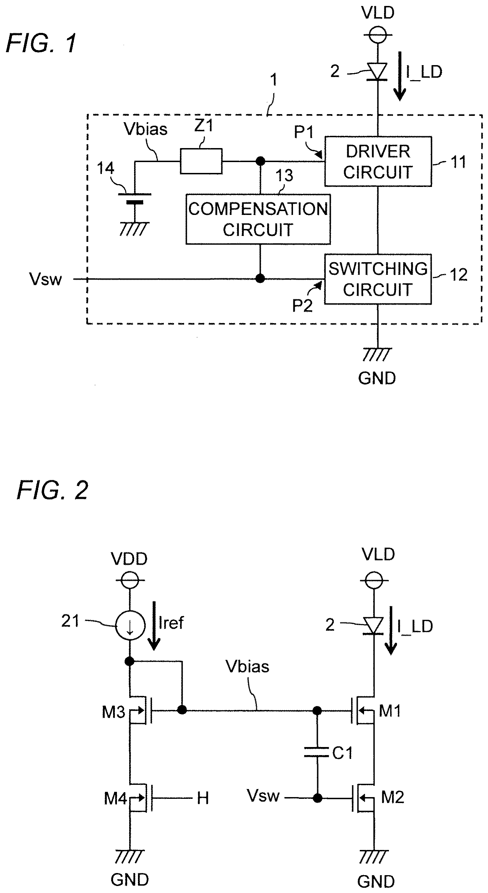

Fig. 1 is a block diagram showing a basic configuration of a semiconductor laser drive device 1 according to a first embodiment. The semiconductor laser drive device 1 drives a semiconductor laser element 2 by supplying a drive current I_LD to the semiconductor laser element 2.

The semiconductor laser element 2 is, for example, a laser diode. An anode of the semiconductor laser element 2 is connected to a terminal (power supply terminal) of a power supply voltage VLD, and a cathode is connected to a driver circuit 11 (described later) of the semiconductor laser drive device 1. The power supply voltage VLD is set according to specifications, number, and connection of the semiconductor laser elements 2, and it may be set to a high voltage of, e.g., several tens V.

The semiconductor laser drive device 1 is provided with the driver circuit 11, a switching circuit 12, a compensation circuit 13, and a bias voltage source 14.

The bias voltage source 14 generates a bias voltage Vbias corresponding to an upper limit of the drive current I_LD flowing through the semiconductor laser element 2. The semiconductor laser drive device 1 has a finite impedance Z1 associated with the bias voltage source 14.

The driver circuit 11 is connected in series to the semiconductor laser element 2. The driver circuit 11 has a terminal P1 to which a bias voltage Vbias is applied. The driver circuit 11 limits the drive current CLD flowing through the semiconductor laser element 2 so as not to exceed the upper limit corresponding to the magnitude of the bias voltage Vbias.

The switching circuit 12 is connected in series to the semiconductor laser element 2 and the driver circuit 11. The switching circuit 12 has a terminal P2 to which a pulse signal Vsw is applied. The switching circuit 12 is repeatedly turned on and off according to the pulse signal Vsw. The pulse signal Vsw has a frequency of, e.g., 100 to 400 MHz.

As shown in Fig. 1, the semiconductor laser element 2, the driver circuit 11, and the switching circuit 12 may be connected between the terminal of the power supply voltage VLD and a terminal (ground terminal) of the ground voltage GND in an order of the semiconductor laser element 2, the driver circuit 11, and the switching circuit 12.

The driver circuit 11 and the switching circuit 12 are provided with switching elements, such as Nch metal-oxide semiconductor (NMOS) transistors, as described later with reference to Fig. 2. When the switching circuit 12 is turned on and off, a current flows through parasitic capacitance of the switching element of the driver circuit 11. Due to this current, the voltage potential at the terminal P1, that is, the bias voltage Vbias may vary, and as a result, the drive current I_LD may have a long rise time and a long fall time. The semiconductor laser drive device 1 according to the embodiment is provided with the compensation circuit 13 to compensate for variations of the bias voltage Vbias.

The compensation circuit 13 compensates for variations in voltage potential at the terminal P1 based on the pulse signal Vsw, the variations occurring when the switching circuit 12 is turned on and off. Specifically, the compensation circuit 13 generates and supplies a current to the terminal P1 when the switching circuit 12 is turned on and off, the generated current at least partially offsetting the current flowing through the parasitic capacitance of the driver circuit 11.

Fig. 2 is a circuit diagram showing an implementation example of the semiconductor laser drive device 1 of Fig. 1. The semiconductor laser drive device 1 of Fig. 2 is provided with NMOS transistors M1 to M4, a capacitor C1, and a constant current source 21.

The anode of the semiconductor laser element 2 is connected to the terminal of the power supply voltage VLD, and the cathode is connected to a drain of the NMOS transistor M1. A source of the NMOS transistor M1 is connected to a drain of the NMOS transistor M2. A source of the NMOS transistor M2 is connected to the terminal of the ground voltage GND. The pulse signal Vsw is applied to a gate of the NMOS transistor M2.

A back gate of the NMOS transistor M1 may be connected to the source, or may be connected to the terminal of the ground voltage GND.

One end of the capacitor C1 is connected to a gate of the NMOS transistor M1, and the other end is connected to the gate of the NMOS transistor M2.

The constant current source 21 supplies a constant current Iref from the terminal of the power supply voltage VDD to a drain of the NMOS transistor M3. A source of the NMOS transistor M3 is connected to a drain of the NMOS transistor M4. A source of the NMOS transistor M4 is connected to the terminal of the ground voltage GND. A gate of the NMOS transistor M3 is connected to the drain of the NMOS transistor M3. A voltage equal to a high level (H) of the pulse signal Vsw is applied to a gate of the NMOS transistor M4.

The gate of the NMOS transistor M1 is connected to the gate and the drain of the NMOS transistor M3, and thus, the NMOS transistors M1 and M3 constitute a current mirror circuit. For example, consider a case where the NMOS transistors M1 and M3 have the same gate length L1 = L3, and have different gate widths W1 : W3 = 256 : 1, respectively. In this case, a current of Iref flows between the drain and source of the NMOS transistor M3, and a current of Iref × 256 flows between the drain and source of the NMOS transistor M1.

The NMOS transistor M1 is an example of the driver circuit 11. The gate of the NMOS transistor M1 corresponds to the terminal P1. The NMOS transistor M2 is an example of the switching circuit 12. The gate of the NMOS transistor M2 corresponds to the terminal P2. The capacitor C1 is an example of the compensation circuit 13. A circuit including the NMOS transistors M1, M3, and M4 and the constant current source 21 is an example of the bias voltage source 14. The impedance Z1 corresponds to an internal impedance of the current mirror circuit (NMOS transistors M1 and M3).

[OPERATION OF FIRST EMBODIMENT]

As described above, when the switching circuit 12 is turned on and off, the bias voltage Vbias, that is, the gate voltage of the NMOS transistor M1 varies due to the current flowing through the parasitic capacitance of the driver circuit 11, and as a result, the drive current I_LD may have a long rise time and a long fall time.

It is possible to reduce variations of the bias voltage Vbias by reducing the impedance Z1 in some way. The magnitude of the impedance Z1 depends on the method for supplying the bias voltage Vbias. When a common circuit, such as a current mirror circuit, generates the bias voltage Vbias, the impedance Z1 is often large. However, reducing the impedance Z1 makes it difficult to achieve all of high output power, high-speed driving, and low power consumption. For example, while the impedance Z1 can be reduced by appropriately setting a ratio of gate areas of transistors included in the current mirror circuit, the smaller the impedance Z1 is, the more the steady current flows, and thus, low power consumption is unachievable.

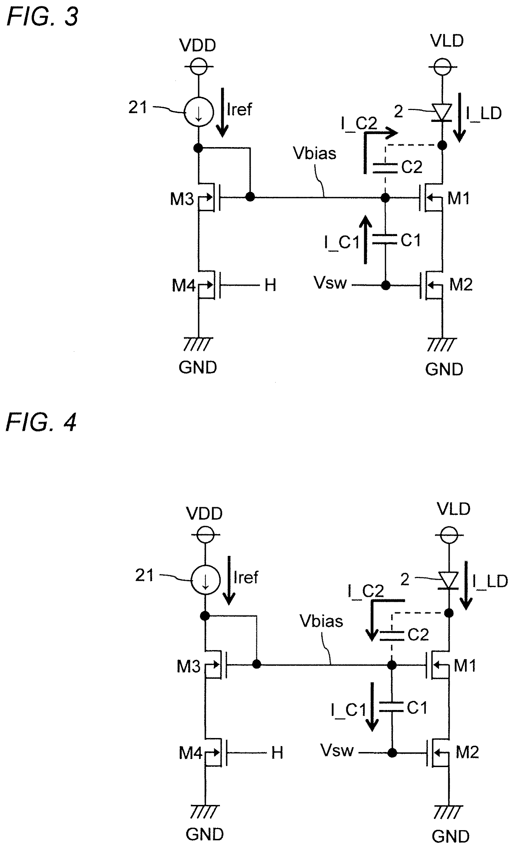

Hereinafter, a method for compensating for variations of the bias voltage Vbias using the compensation circuit 13 will be described with reference to Figs. 3 to 5.

Fig. 3 is a diagram showing currents flowing in the semiconductor laser drive device 1 of Fig. 2 when an NMOS transistor M2 is turned on. When the NMOS transistor M2 is turned on, the drive current I_LD starts flowing through the semiconductor laser element 2. As the drive current I_LD increases, the drain voltage Vd_M1 of the NMOS transistor M1 gradually decreases. At this time, a current I_C2 flows from the gate to the drain of the NMOS transistor M1 through the parasitic capacitance C2 between the gate and the drain of the NMOS transistor M1, and the gate voltage of the NMOS transistor M1 decreases. As the parasitic capacitance C2 increases, the influence of this capacitive coupling also increases. In other words, a transient decrease in the gate voltage of the NMOS transistor M1 due to capacitive coupling increases in proportion to the gate width and the gate length of the NMOS transistor M1. When the gate width of the NMOS transistor M1 is increased for high output power, the gate voltage of the NMOS transistor M1 decreases accordingly, thus hindering the rise of the drive current I_LD.

In the semiconductor laser drive device 1 according to the embodiment, when the NMOS transistor M2 is turned on, that is, when the pulse signal Vsw transitions from a low level to a high level, a current I_C1 flows from the gate of the NMOS transistor M2 to the gate of the NMOS transistor M1 through the capacitor C1, and the gate voltage of the NMOS transistor M1 increases. This at least partially offsets the decrease in the gate voltage of the NMOS transistor M1 due to the current flowing through the parasitic capacitance C2.

Fig. 4 is a diagram showing currents flowing in the semiconductor laser drive device 1 of Fig. 2 when an NMOS transistor M2 is turned off. When the NMOS transistor M2 is turned off, the drive current I_LD having flowed by then decreases. As the drive current I_LD decreases, a drain voltage Vd_M1 of the NMOS transistor M1 gradually increases. At this time, the current I_C2 flows from the drain to the gate of the NMOS transistor M1 through the parasitic capacitance C2, and the gate voltage of the NMOS transistor M1 increases. As described above, as the parasitic capacitance C2 increases, the influence of this capacitive coupling also increases. In other words, a transient increase in the gate voltage of the NMOS transistor M1 due to capacitive coupling increases in proportion to the gate width and the gate length of the NMOS transistor M1. When the gate width of the NMOS transistor M1 is increased for high output power, the gate voltage of the NMOS transistor M1 increases accordingly, thus hindering the fall of the drive current I_LD.

In the semiconductor laser drive device 1 according to the embodiment, when the NMOS transistor M2 is turned off, that is, when the pulse signal Vsw transitions from the high level to the low level, the current I_C1 flows from the gate of the NMOS transistor M1 to the gate of the NMOS transistor M2 through the capacitor C1, and the gate voltage of the NMOS transistor M1 decreases. This at least partially offsets the increase in the gate voltage of the NMOS transistor M1 due to the current flowing through the parasitic capacitance C2.

By determining the capacitance of the capacitor C1 so as to satisfy I_C1 = I C2, it is possible to make variations of the gate voltage of the NMOS transistor M1, occurring when the NMOS transistor M2 is turned on and off, to zero. Thus, it is possible to achieve high-speed driving without hindering the rises and the falls of the driving current I_LD.

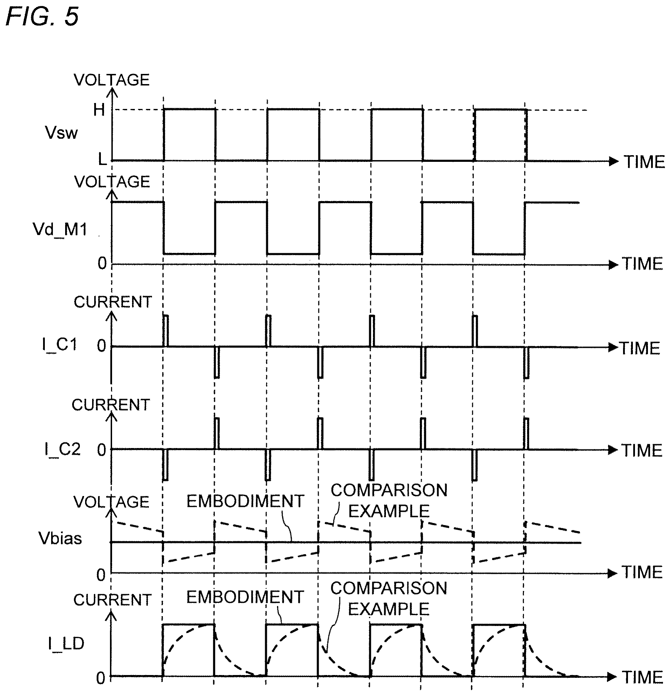

Fig. 5 is a timing chart showing an operation of the semiconductor laser drive device 1 of Fig. 2. Fig. 5 shows temporal changes of the pulse signal Vsw, the drain voltage Vd_M1 of the NMOS transistor M1, the current I_C1 flowing through the capacitor C1, the current I_C2 flowing through the parasitic capacitance C2, the bias voltage Vbias, and the drive current I_LD of the semiconductor laser element 2. In each of of the currents I_C1 and I_C2, a direction flowing into the gate of the NMOS transistor M1 is defined as a positive direction, and a direction flowing from the gate of the NMOS transistor M1 is defined as a negative direction. In each of the fifth and sixth rows of Fig. 5, a solid line indicates the operation of the semiconductor laser drive device 1 of Fig. 2 (embodiment), and a broken line indicates an operation of a comparison example in which the capacitor C1 is removed from the semiconductor laser drive device 1 of Fig. 2.

In the comparison example, the bias voltage Vbias largely varies when the NMOS transistor M2 is turned on and off, as indicated by the broken line in Fig. 5. When the NMOS transistor M2 is turned on, the current flows through the parasitic capacitance C2, and the bias voltage Vbias decreases, and thus, it is not possible to achieve a gate-source voltage of the NMOS transistor M1 according to a desired drive current I_LD. Thus, the drive current I_LD has a long rise time. In addition, when the NMOS transistor M2 is turned off, the drive current I_LD keeps flowing for a while through the parasitic capacitance C2, and the bias voltage Vbias increases. Thus, the drive current I_LD has a long fall time.

On the other hand, in the embodiment, since the compensation circuit 13 (or the capacitor C1) is provided, it is possible to compensate for variations of the bias voltage Vbias occurring when the NMOS transistor M2 is turned on and off, as indicated by the solid line in Fig. 5. The bias voltage Vbias does not vary, the drive current I_LD do not have a long rise time and a long fall time, and the drive current I_LD has a waveform capable of achieving a high-speed driving.

In general, as the output power increases, the parasitic capacitance of the driver circuit increases, and the current transiently flowing through the parasitic capacitance also increases. In this case, conventionally, it is difficult to keep the bias voltage applied to the driver circuit constant, the drive current I_LD has a long rise time and a long fall time, and the driving speed decreases. On the other hand, according to the embodiment, when the switching circuit 12 is turned on and off, a current having the same magnitude as that of the current flowing through the parasitic capacitance of the driver circuit 11 flows through the compensation circuit 13. This can at least partially offset variations of the bias voltage Vbias, and achieve high output power while mitigating a decrease in driving speed. In addition, according to the embodiment, it is not necessary to keep a current flowing through another path when the semiconductor laser element 2 is turned off, as opposed to the differential pair circuit as disclosed in Patent Document 1, and thus, it is possible to achieve a lower power consumption as compared with the prior art.

Thus, the semiconductor laser drive device 1 according the embodiment can drive the semiconductor laser element 2 so as to achieve all of high output power, high-speed driving, and low power consumption.

[MODIFIED EMBODIMENT OF FIRST EMBODIMENT]

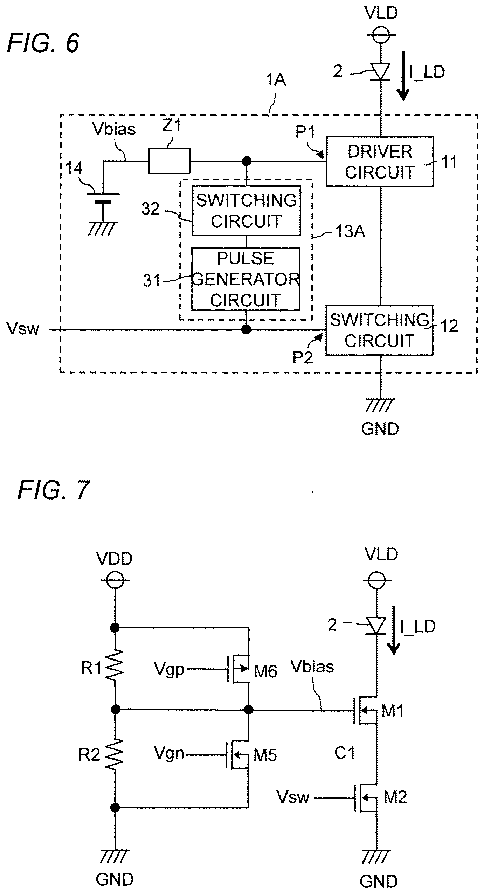

Fig. 6 is a block diagram showing a basic configuration of a semiconductor laser drive device 1A according to a modified embodiment of the first embodiment. The semiconductor laser drive device 1A is provided with a compensation circuit 13A instead of the compensation circuit 13 of Fig. 1.

The compensation circuit 13A is provided with a pulse generator circuit 31 and a switching circuit 32. The switching circuit 32 includes one or more switching elements, such as an NMOS transistor and/or a Pch metal-oxide semiconductor (PMOS) transistor. The pulse generator circuit 31 generates one or more pulse signals for controlling the switching element of the switching circuit 32, based on the pulse signal Vsw. The compensation circuit 13A generates and supplies a current to the terminal P1 over time periods immediately after rises and falls of the pulse signal Vsw and shorter than the periods and OFF periods of the switching circuit 12, the generated current at least partially offsetting the current flowing through the parasitic capacitance of the driver circuit 11. The compensation circuit 13A may generate a current for offsetting the current flowing through the parasitic capacitance of the driver circuit 11, only when the switching circuit 12 is turned on and off and a current is flowing through the parasitic capacitance of the driver circuit 11.

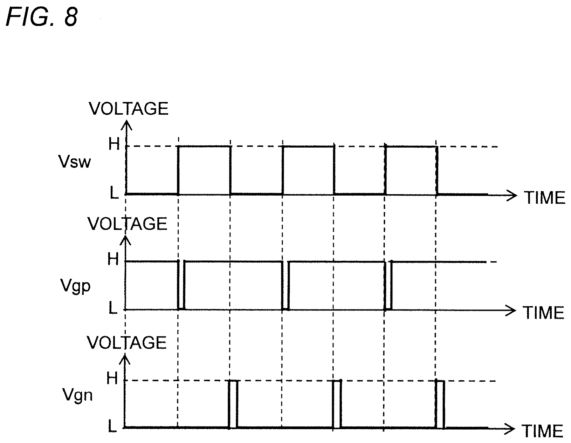

Fig. 7 is a circuit diagram showing an implementation example of the semiconductor laser drive device 1A of Fig. 6. The semiconductor laser drive device 1A of Fig. 7 is provided with NMOS transistors M1, M2, and M5, a PMOS transistor M6, and resistors R1 and R2. In addition, the pulse generator circuit 31 (not shown in Fig. 7) generates pulse signals Vgp and Vgn based on the pulse signal Vsw as described later with reference to Fig. 8.

The NMOS transistors M1 and M2 of Fig. 7 are configured in a manner similar to that of the NMOS transistors M1 and M2 of Fig. 2.

The resistors R1 and R2 are voltage dividing resistors connected in series between the terminal of the power supply voltage VDD and the terminal of the ground voltage GND. The node between the resistors R1 and R2 is connected to the gate of the NMOS transistor M1. Thus, a voltage VDD x R2/(R1 + R2) is applied to the gate of the NMOS transistor M1 as the bias voltage Vbias.

A source of the PMOS transistor M6 is connected to the terminal of the power supply voltage VDD, and a drain of the PMOS transistor M6 is connected to a drain of the NMOS transistor M5. A source of the NMOS transistor M5 is connected to the terminal of the ground voltage GND. The pulse signal Vgp is applied to a gate of the PMOS transistor M6. The pulse signal Vgn is applied to a gate of the NMOS transistor M5. The drain of the PMOS transistor M6 and the drain of the NMOS transistor M5 are connected to the gate of the NMOS transistor M1.

The source of the PMOS transistor M6 may be connected to the terminal of the power supply voltage VDD common to the resistors R1 and R2 as shown in Fig. 7, or may be connected to any other power supply as long as not affecting the on/off operation of the switching circuit 12.

The NMOS transistor M1 is an example of the driver circuit 11. The gate of the NMOS transistor M1 corresponds to the terminal P1. The NMOS transistor M2 is an example of the switching circuit 12. The gate of the NMOS transistor M2 corresponds to the terminal P2. The PMOS transistor M6 and the NMOS transistor M5 are examples of the switching circuit 32. The resistors R1 and R2 are examples of the bias voltage source 14. The impedance Z1 corresponds to the total resistance of the resistors R1 and R2.

Fig. 8 is a timing chart showing an operation of the pulse generator circuit 31 of Fig. 6. The pulse generator circuit 31 generates a pulse signal Vgp and a pulse signal Vgn, the pulse signal Vgp being set to a low level only in time periods immediately after the rises of the pulse signal Vsw and shorter than the ON periods of the switching circuit 12, the pulse signal Vgn being set to a high level only in time periods immediately after the falls of the pulse signal Vsw and shorter than the OFF periods of the switching circuit 12. The PMOS transistor M6 is turned on and off according to the pulse signal Vgp. The NMOS transistor M5 is turned on and off according to the pulse signal Vgn.

The pulse signal Vgp may be generated to be at a low level, only when the NMOS transistor M2 transitions from OFF to ON and the current I_C2 is flowing from the gate to the drain of the NMOS transistor M1 through the parasitic capacitance C2. In this case, the PMOS transistor M6 allows the current to flow from the terminal of the power supply voltage VDD to the gate of the NMOS transistor M1, only when the current I_C2 is flowing from the gate to the drain of the NMOS transistor M1 through the parasitic capacitance C2. In addition, the pulse signal Vgn may be generated to be at a high level, only when the NMOS transistor M2 transitions from ON to OFF and the current I_C2 is flowing from the drain to the gate of the NMOS transistor M1 through the parasitic capacitance C2. In this case, the NMOS transistor M5 allows the current to flow from the gate of the NMOS transistor M1 to the terminal of the ground voltage GND, only when the current I_C2 is flowing from the drain to the gate of the NMOS transistor M1 through the parasitic capacitance C2.

Since the pulse generator circuit 31 generates the pulse signals Vgp and Vgn in such a manner, the compensation circuit 13A generates an offsetting current, only when the switching circuit 12 is turned on and off and the current I_C2 is flowing through the parasitic capacitance of the driver circuit 11.

The semiconductor laser drive device 1A according to the modified embodiment of the first embodiment can at least partially offset the current flowing through the parasitic capacitance of the driver circuit 11, and compensate for variations of the bias voltage Vbias, in a manner similar to that of the semiconductor laser drive device 1 of Fig. 1. Thus, the semiconductor laser drive device 1A can drive the semiconductor laser element 2 so as to achieve all of high output power, high-speed driving, and low power consumption, in a manner similar to that of the semiconductor laser drive device 1 of Fig. 1. In addition, the semiconductor laser drive device 1A can operate more effectively by generating an offsetting current only when a current is flowing through the parasitic capacitance of the driver circuit 11, as compared with the case of using the compensation circuit 13 including the capacitor C1.

[SECOND EMBODIMENT]

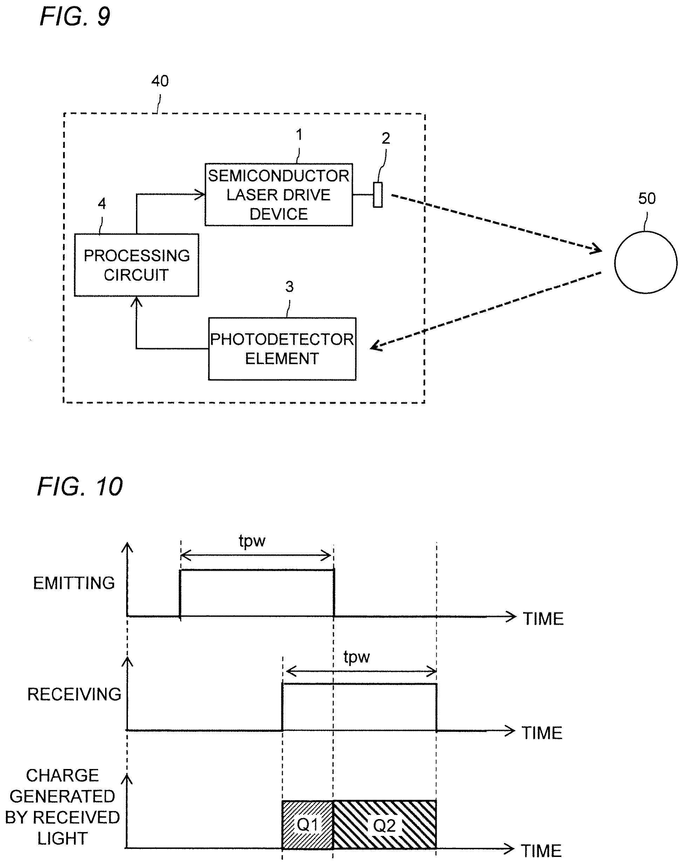

Fig. 9 is a block diagram showing a basic configuration of a distance measurement apparatus 40 according to a second embodiment. The distance measurement apparatus 40 is provided with a semiconductor laser drive device 1, a semiconductor laser element 2, a photodetector element 3, and a processing circuit 4. The semiconductor laser drive device 1 and the semiconductor laser element 2 of Fig. 9 are configured in a manner similar to that of the corresponding components of Fig. 1. The photodetector element 3 obtains a quantity of reflected light indicating the quantity of light generated by the semiconductor laser element 2 and reflected by a target object 50. The processing circuit 4 calculates the distance from the distance measurement apparatus 40 to the target object 50 based on the quantity of reflected light. The processing circuit 4 generates the pulse signal Vsw in Fig. 1. The distance measurement apparatus 40 is, for example, a ToF sensor that obtains a three-dimensional image of the target object 50 as seen from the distance measurement apparatus 40.

Fig. 10 is a schematic view for explaining distance measurement with the distance measurement apparatus 40 of Fig. 9. The pulse signal Vsw has a pulse time width tpw, and the semiconductor laser element 2 emits light over the pulse time width tpw. The processing circuit 4 receives reflected light of the target object during and after light emission, and obtains a quantity of received light Q1 during light emission and a quantity of received light Q2 after light emission. For the light speed c, the distance D from the distance measurement apparatus 40 to the target object 50 is calculated as follows.
$$D = c \times tpw \times Q2/(Q1 + Q2)/2$$

Since the distance measurement apparatus 40 of Fig. 9 is provided with the semiconductor laser drive device 1 according the first embodiment, the distance measurement apparatus 40 can drive the semiconductor laser element 2 so as to achieve all of high-speed driving, and low power consumption.

[OTHER MODIFIED EMBODIMENTS]

The driver circuit 11 and the switching circuit 12 are not limited to those configured by NMOS transistors, and may be configured by PMOS transistors, bipolar transistors, or the like.

In the case of using a high supply voltage VLD, the driver circuit 11 may be provided with a high breakdown voltage element, for example, a laterally-diffused metal-oxide semiconductor (LDMOS).

The semiconductor laser element 2, the driver circuit 11, and the switching circuit 12 may be connected between the terminal of the power supply voltage VLD and the terminal of the ground voltage GND in the order as shown in Figs. 1 and 6, or may be connected therebetween in any other order. By connecting the semiconductor laser element 2, the driver circuit 11, and the switching circuit 12 in the order as shown in Figs. 1 and 6, it is possible to reduce the voltage of the pulse signal Vsw as low as possible, thus avoiding a decrease in response speed. In addition, by connecting the semiconductor laser element 2, the driver circuit 11, and the switching circuit 12 in the order as shown in Figs. 1 and 6, it is possible to reduce a current consumption of a generation circuit (not shown) of the pulse signal Vsw, as compared with the case of connecting them in other orders. In this case, the pulse signal Vsw may have a relatively low high-level voltage, such as 1.8 V.

The configurations described in the embodiments are merely examples. The configuration of the compensation circuit, the method for generating the bias voltage, and others are not limited to those disclosed, but may be arbitrarily combined.

[SUMMARY OF EMBODIMENTS]

According to a semiconductor laser drive device 1 of a first aspect of the present disclosure, the semiconductor laser drive device 1 for driving a semiconductor laser element 2 is provided with: a driver circuit 11, a switching circuit 12, and a compensation circuit 13. The driver circuit 11 is connected in series to the semiconductor laser element 2, the driver circuit 11 having a first terminal P1 to which a bias voltage Vbias is applied, the driver circuit 11 being configured to limit a current flowing through the semiconductor laser element 2 so as not to exceed an upper limit corresponding to a magnitude of the bias voltage Vbias. The switching circuit 12 is connected in series to the semiconductor laser element 2 and the driver circuit 11, the switching circuit 12 having a second terminal P2 to which a first pulse signal Vsw is applied, the switching circuit 12 being repeatedly turned on and off according to the first pulse signal Vsw. The compensation circuit 13 is configured to compensate for variations in voltage potential at the first terminal P1 based on the first pulse signal Vsw, the variations occurring when the switching circuit 12 is turned on and off.

According to a semiconductor laser drive device 1 of a second aspect of the present disclosure, the semiconductor laser drive device 1 of the first aspect may be configured as follows. The compensation circuit 13 generates and supplies a current to the first terminal P1 when the switching circuit 12 is turned on and off, the generated current at least partially offsetting a current flowing through a parasitic capacitance of the driver circuit 11.

According to a semiconductor laser drive device 1 of a third aspect of the present disclosure, the semiconductor laser drive device 1 of the second aspect may be configured as follows. The driver circuit 11 is provided with a first NMOS transistor M1, and the first terminal P1 is a gate of the first NMOS transistor M1. The switching circuit 12 is provided with a second NMOS transistor M2, and the second terminal P2 is a gate of the second NMOS transistor M2. The compensation circuit 13 is provided with a capacitor connected between the first and second terminal P2s.

According to a semiconductor laser drive device 1 of a fourth aspect of the present disclosure, the semiconductor laser drive device 1 of the second aspect may be configured as follows. The compensation circuit 13A generates and supplies a current to the first terminal P1 over time periods immediately after rises and falls of the first pulse signal Vsw and shorter than ON periods and OFF periods of the switching circuit 12, the generated current at least partially offsetting the current flowing through the parasitic capacitance of the driver circuit 11.

According to a semiconductor laser drive device 1 of a fifth aspect of the present disclosure, the semiconductor laser drive device 1 of the fourth aspect may be configured as follows. The driver circuit 11 is provided with a first NMOS transistor M1, and the first terminal P1 is a gate of the first NMOS transistor M1. The switching circuit 12 is provided with a second NMOS transistor M2, and the second terminal P2 is a gate of the second NMOS transistor M2. The compensation circuit 13A is provided with: a pulse generator circuit 31, a first PMOS transistor M6, and a third NMOS transistor M5. The pulse generator circuit 31 is configured to generate a second pulse signal Vgp and a third pulse signal Vgn, the second pulse signal Vgp being set to a low level only in time periods immediately after the rises of the first pulse signal Vsw and shorter than the ON periods of the switching circuit 12, the third pulse signal Vgn being set to a high level only in time periods immediately after the falls of the first pulse signal Vsw and shorter than the OFF periods of the switching circuit 12. The first PMOS transistor M6 is connected between the first terminal P1 and a power supply terminal, the first PMOS transistor M6 being turned on and off according to the second pulse signal Vgp. The third NMOS transistor M5 is connected between the first terminal P1 and a ground terminal, the third NMOS transistor M5 being turned on and off according to the third pulse signal Vgn.

According to a semiconductor laser drive device 1 of a sixth aspect of the present disclosure, the semiconductor laser drive device 1 of one of the first to fifth aspects may be configured as follows. The semiconductor laser element 2, the driver circuit 11, and the switching circuit 12 are connected between a power supply terminal and a ground terminal in an order of the semiconductor laser element 2, the driver circuit 11, and the switching circuit 12.

According to a distance measurement apparatus 40 of a seventh aspect of the present disclosure, the distance measurement apparatus is provided with: the semiconductor laser drive device 1 of one of the first to sixth aspects; a semiconductor laser element 2; a photodetector element 3 configured to obtain a quantity of reflected light indicating a quantity of light generated by the semiconductor laser element 2 and reflected by a target object; and a processing circuit 4 configured to calculate a distance to the target object based on the quantity of reflected light.

REFERENCE SIGNS LIST

    1, 1A: semiconductor laser drive device
    2: semiconductor laser element
    3: photodetector element
    4: processing circuit
    11: driver circuit
    12: switching circuit
    13, 13A: compensation circuit
    14: bias voltage source
    21: constant current source
    31: pulse generator circuit
    32: switching circuit
    40: distance measurement apparatus
    50: target object
    C1: capacitor
    C2: parasitic capacitance
    M1 to M5: NMOS transistor
    M6: PMOS transistor
    R1, R2: resistor
    Z1: impedance

**Claims**

1. A semiconductor laser drive device for driving a semiconductor laser element, the semiconductor laser drive device comprising:

    a driver circuit connected in series to the semiconductor laser element, the driver circuit having a first terminal to which a bias voltage is applied, the driver circuit being configured to limit a current flowing through the semiconductor laser element so as not to exceed an upper limit corresponding to a magnitude of the bias voltage;

a switching circuit connected in series to the semiconductor laser element and the driver circuit, the switching circuit having a second terminal to which a first pulse signal is applied, the switching circuit being repeatedly turned on and off according to the first pulse signal; and
a compensation circuit configured to compensate for variations in voltage potential at the first terminal based on the first pulse signal, the variations occurring when the switching circuit is turned on and off.

2. The semiconductor laser drive device as claimed in claim 1,
wherein the compensation circuit generates and supplies a current to the first terminal when the switching circuit is turned on and off, the generated current at least partially offsetting a current flowing through a parasitic capacitance of the driver circuit.

3. The semiconductor laser drive device as claimed in claim 2,

wherein the driver circuit comprises a first Nch metal-oxide semiconductor (NMOS) transistor, and the first terminal is a gate of the first NMOS transistor,
wherein the switching circuit comprises a second NMOS transistor, and the second terminal is a gate of the second NMOS transistor, and
wherein the compensation circuit comprises a capacitor connected between the first and second terminals.

4. The semiconductor laser drive device as claimed in claim 2,
wherein the compensation circuit generates and supplies a current to the first terminal over time periods immediately after rises and falls of the first pulse signal and shorter than ON periods and OFF periods of the switching circuit, the generated current at least partially offsetting the current flowing through the parasitic capacitance of the driver circuit.

5. The semiconductor laser drive device as claimed in claim 4,

wherein the driver circuit comprises a first NMOS transistor, and the first terminal is a gate of the first NMOS transistor,
wherein the switching circuit comprises a second NMOS transistor, and the second terminal is a gate of the second NMOS transistor,
wherein the compensation circuit comprises:

a pulse generator circuit configured to generate a second pulse signal and a third pulse signal, the second pulse signal being set to a low level only in time periods immediately after the rises of the first pulse signal and shorter than the ON periods of the switching circuit, the third pulse signal being set to a high level only in time periods immediately after the falls of the first pulse signal and shorter than the OFF periods of the switching circuit;
a first Pch metal-oxide semiconductor (PMOS) transistor connected between the first terminal and a power supply terminal, the first PMOS transistor being turned on and off according to the second pulse signal; and
a third NMOS transistor connected between the first terminal and a ground terminal, the third NMOS transistor being turned on and off according to the third pulse signal.

6. The semiconductor laser drive device as claimed in claim 1,
wherein the semiconductor laser element, the driver circuit, and the switching circuit are connected between a power supply terminal and a ground terminal in an order of the semiconductor laser element, the driver circuit, and the switching circuit.

7. A distance measurement apparatus comprising:

the semiconductor laser drive device as claimed in claim 1;
a semiconductor laser element;
a photodetector element configured to obtain a quantity of reflected light indicating a quantity of light generated by the semiconductor laser element and reflected by a target object; and
a processing circuit configured to calculate a distance to the target object based on the quantity of reflected light.

*FIG. 1*

*FIG. 2*

## FIG. 3

## FIG. 4

*FIG. 5*

*FIG. 6*

VLD

2 ⟋

I_LD

1A

Vbias    Z1    P1

DRIVER
CIRCUIT    11

14

SWITCHING
CIRCUIT    32

13A

PULSE
GENERATOR
CIRCUIT    31

Vsw

SWITCHING
CIRCUIT    12

P2

GND

*FIG. 7*

VDD

VLD

2 ⟋

I_LD

R1    Vgp —| M6    Vbias

M1

Vgn —| M5    C1

R2

Vsw —| M2

GND    GND

FIG. 8

## FIG. 9

## FIG. 10

## INTERNATIONAL SEARCH REPORT

| International application No. |
|---|
| **PCT/JP2023/008014** |

| A. CLASSIFICATION OF SUBJECT MATTER |
|---|
| ***H01S 5/062***(2006.01)i<br>FI: H01S5/062 |
| According to International Patent Classification (IPC) or to both national classification and IPC |

| B. FIELDS SEARCHED |
|---|
| Minimum documentation searched (classification system followed by classification symbols)<br>H01S5/00-5/50 |
| Documentation searched other than minimum documentation to the extent that such documents are included in the fields searched<br>Published examined utility model applications of Japan 1922-1996<br>Published unexamined utility model applications of Japan 1971-2023<br>Registered utility model specifications of Japan 1996-2023<br>Published registered utility model applications of Japan 1994-2023 |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| A | JP 2007-142316 A (NEC ELECTRONICS CORPORATION) 07 June 2007 (2007-06-07)<br>entire text, all drawings | 1-7 |
| A | JP 2019-192735 A (NICHIA CORPORATION) 31 October 2019 (2019-10-31)<br>entire text, all drawings | 1-7 |
| A | JP 2018-200969 A (SHIMADZU CORPORATION) 20 December 2018 (2018-12-20)<br>entire text, all drawings | 1-7 |
| A | WO 2020/012880 A1 (SONY SEMICONDUCTOR SOLUTIONS CORP.) 16 January 2020 (2020-01-16)<br>entire text, all drawings | 1-7 |
| A | US 2021/0234336 A1 (STMICROELECTRONICS (GRENOBLE 2) SAS) 29 July 2021 (2021-07-29)<br>entire text, all drawings | 1-7 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/008014**

| Patent document cited in search report | | | Publication date (day/month/year) | Patent family member(s) | | | Publication date (day/month/year) |
|---|---|---|---|---|---|---|---|
| JP | 2007-142316 | A | 07 June 2007 | US | 2007/0116075 | A1 | |
| JP | 2019-192735 | A | 31 October 2019 | US | 2019/0326727 | A1 | |
| | | | | CN | 110391588 | A | |
| JP | 2018-200969 | A | 20 December 2018 | US | 2018/0342852 | A1 | |
| | | | | CN | 108933380 | A | |
| WO | 2020/012880 | A1 | 16 January 2020 | US | 2021/0273404 | A1 | |
| US | 2021/0234336 | A1 | 29 July 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6922505 B